# EUROPÄISCHE PATENTSCHRIFT

(11) **EP 1 536 456 B1**
(45) Veröffentlichungstag und Bekanntmachung des Hinweises auf die Patenterteilung: **15.02.2012**
(21) Anmeldenummer: 04027994.5
(22) Anmeldetag: 25.11.2004
(51) Int. Cl.: H01L 21/00, C23C 14/50, B65G 49/06

(54) **Trägeranordnung**
Support structure
Structure de support

(30) Priorität: 28.11.2003 DE 10355682
(43) Veröffentlichungstag der Anmeldung: 01.06.2005
(73) Patentinhaber: Singulus Technologies AG, 63796 Kahl/Main (DE)
(72) Erfinder: Kempf, Stefan, 63755 Alzenau (DE); Merz, Thomas, 63739 Aschaffenburg (DE)
(74) Vertreter: Vossius & Partner

(56) Entgegenhaltungen:
- EP-A- 0 326 838
- WO-A-01/46996
- DE-U1- 9 307 263
- US-A- 6 120 609

## Beschreibung

Die Erfindung betrifft eine Trägeranordnung bzw. eine Vorrichtung zur Positionierung und Führung eines Trägerelements als bewegbares Teil in einem Träger. Dieses bewegbare Teil (oder Trägersegment) wird in dem Träger gehaltert und durch einen Stößel (z.B. Hubdeckel) um eine bestimmte Hubstrecke herausgehoben, um zum Beispiel an einer anderen Einrichtung positioniert zu werden.

Bei einer derartigen Vorrichtung kann das Problem auftreten, daß das Trägerelement nicht exakt geführt wird, zum Beispiel verkantet und nicht genau positioniert bzw. relativ zu einer anderen Einrichtung ausgerichtet werden kann.

Aus der EP-B1-0 443 049 und der EP-B1-0 449 227 sind bewegbare Teile in Trägem in Vakuumkammern bekannt, die zur Aufnahme von Substraten vorgesehen sind und jeweils durch einen Stößel aus dem Träger herausgehoben und gegen die Öffnung der Vakuumkammer gepreßt werden. Die Träger weisen Dichtmittel auf, so daß die Abdichtung der Vakuumkammer durch Andrücken des Trägers an die Öffnung sicher gestellt ist. Die Führung und Positionierung des bewegbaren Teils erfolgt lediglich durch den Stößel, wobei geringe Abweichungen von der Anpreßrichtung auftreten können.

US 6 120 609 A, WO 01/46996 A und EP 0 326 838 beschreiben eine Trägeranordnung entsprechend dem Oberbegriff des Anspruchs 1.

Der Erfindung liegt die Aufgabe zugrunde, eine Trägeranordnung mit einer verbesserten Positionierung und Führung eines Trägerelements relativ zum Träger zur Verfügung zu stellen. Diese Aufgabe wird mit den Merkmalen von Anspruch 1 gelöst. Bevorzugte Ausführungsformen sind in den Ansprüchen 2 bis 17 definiert.

Bei der Lösung geht die Erfindung von folgenden Grundgedanken aus.

Die erfindungsgemäße Trägeranordnung weist ein Trägerelement auf, das in einem Träger über eine Federanordnung gehaltert ist. Weiterhin ist eine Hubanordnung vorgesehen, mit der das Trägerelement gegen die Kraft der Federanordnung um eine vorbestimmte Hubstrecke aus dem Träger herausgedrückt werden kann.
Mit Hilfe einer Führungseinrichtung wird auf der Hubstrecke eine präzise Linearführung des Trägerelements relativ zum Träger sichergestellt. Die Führungseinrichtung weist vorzugsweise Blattfedern auf, deren beide Federenden bzw. Federseiten mit dem Träger bzw. dem Trägerelement verbunden sind. Blattfedern sind besonders gut geeignet, da sie nur einen linearen Federweg aufweisen. So sind die Blattfedern in der Bewegungsrichtung auslenkbar und sonst starr, so daß eine seitliche Verschiebung des Trägerelements während des Heraushebens aus dem Träger und des Andrückens an eine andere Einrichtung zuverlässig vermieden wird.

In vorteilhafter Weise können sowohl die Federanordnung als auch die Führungseinrichtung durch einen einzigen Federtyp ausgebildet sein; in diesem Fall wird auch die Federanordnung durch Blattfedern gebildet. Dabei sind die Blattfedern sowohl zur Ausübung einer Federkraft entgegengesetzt zur Bewegung der Hubanordnung als auch zur Führung des Trägerelements vorgesehen, so daß Abweichungen des Trägerelements von der Soll-Bewegungsrichtung während des Heraushebens und Positionierens vermieden werden.

Besonders bevorzugt ist es jedoch, die Federanordnung und die Führungsanordnung durch zwei Federtypen auszubilden. Vorzugsweise weist dabei die Führungsanordnung Blattfedern auf, die in diesem Falle jedoch in erster Linie nur der Positionierung und Führung dienen, während - abhängig von ihrer Einbaurichtung - ihre (im Vergleich zur Federkraft der Federanordnung relative kleine) Zugkraft bzw. Druckkraft die Wirkung der Federanordnung unterstützt.

Die Federanordnung kann je nach Einbaurichtung zwischen dem Träger und dem Trägerelement als Druckfederanordnung oder als Zugfederanordnung ausgebildet sein; entsprechendes gilt für die Blattfedern der Führungseinrichtung. Dies wir im Zusammenhang mit der Ausführungsform noch näher erläutert.

Die Federanordnung weist mindestens zwei Federelemente, vorzugsweise drei oder mehr Federelemente auf, die vorzugsweise im gleichmäßigen Abstand auf dem Umfang des Trägerelements angeordnet sind. Im Fall eines kreisförmigen Trägerelements sind zum Beispiel drei Federelemente im Abstand von 120° angeordnet.

Entsprechendes gilt für die Blattfedern der Führungseinrichtung, die bei getrennter Anordnung gegenüber der Federelemente der Federanordnung in Umfangsrichtung versetzt sind, zum Beispiel um 60° im Falle von jeweils drei Blattfedern und drei Federelementen.

Vorzugsweise ist die erfindungsgemäße Vorrichtung in einer Vakuumkammer angeordnet und mit einer Öffnung in der Vakuumkammerwand kombiniert, die in Verbindung mit einer anderen Einrichtung zum Beispiel einer Prozeßkammer oder einer Schleusenkammer steht. Durch die Hubanordnung wird das Trägerelement zum Beispiel als Substrathalter mit einem Substrat an die Öffnung der Vakuumkammer gedrückt, wobei eine sehr genaue Verbindung zwischen dem Trägerelement und der Öffnung in der Wand hergestellt wird. Das Substrat kann dann durch die Öffnung in der Vakuumkammerwand hindurch beschichtet oder durch eine Greifeinrichtung abgenommen werden. Das Trägerelement kann in Verbindung mit der Öffnung in der Vakuumkammerwand Bestandteil einer Vakuumschleuse sein, um ein Substrat ein- bzw. auszuschleusen.

Zwischen dem Trägerelement und der Vakuumkammerwand sind vorzugsweise Vakuumdichtungen, z.B. Dichtringe, vorgesehen.

Vorzugsweise wird das Trägerelement in vertikaler Richtung angehoben und angedrückt. Die erfindungsgemäße Vorrichtung kann aber auch so angeordnet sein, daß das Trägerelement in andere Richtungen, z.B. horizontal, bewegt und angedrückt wird.

Die Vorteile der Erfindung liegen in einer verschleißfreien Linearführung, die ohne Schmierung auskommt, und in einer sehr genauen Positionierung bzw. Ausrichtung des bewegbaren Teils an einer mit ihm zu verbindenden Einrichtung. In vorteilhafter Weise kann die Erfindung im Hochvakuum und im Ultrahochvakuum zum Einsatz kommen, da kein Ausgasen oder Kontamination durch Schmierstoffe anfällt.

Im folgenden wird die Erfindung anhand der Zeichnung näher erläutert. Es zeigen:
- Fig. 1: einen Querschnitt durch eine erfindungsgemäße Ausführungsform, die unterhalb einer Öffnung in einer Vakuumkammerwand angeordnet ist;
- Fig. 2: die Ausführungsform gemäß Fig. 1, wobei das Trägerelement an die Öffnung der Vakuumkammerwand gedrückt ist;
- Fig. 3: die Draufsicht auf eine Blattfeder, die in der erfindungsgemäßen Vorrichtung zum Einsatz kommt;
- Fig. 4: die Seitenansicht der Blattfeder gemäß Figur 3 im unbelasteten Zustand; und
- Fig. 5: die Seitenansicht gemäß Fig. 4 im belasteten Zustand mit ausgelenkten Blattfederteilen.

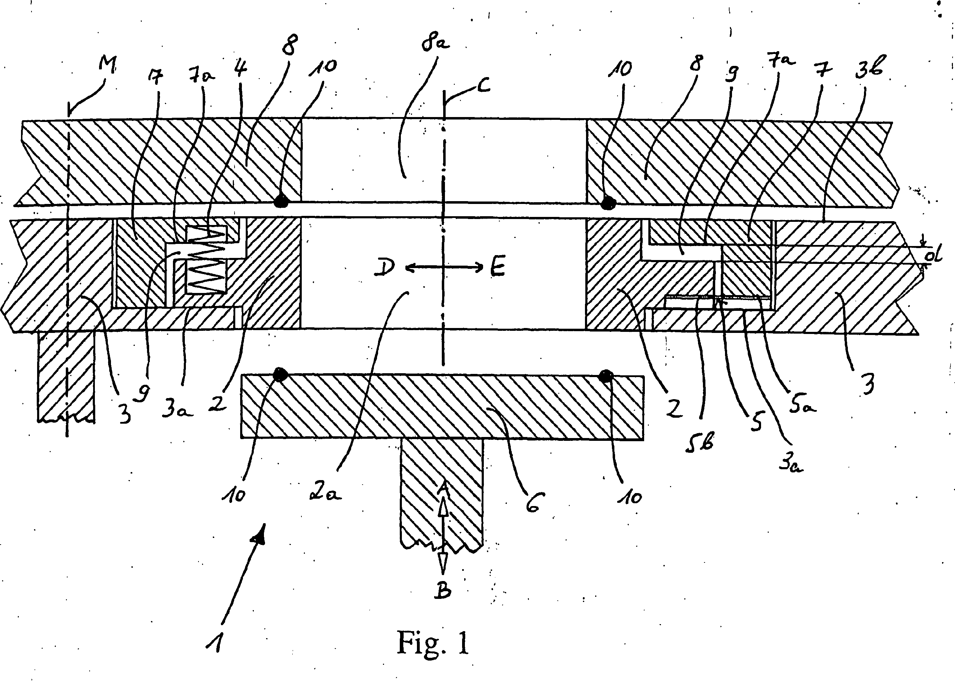

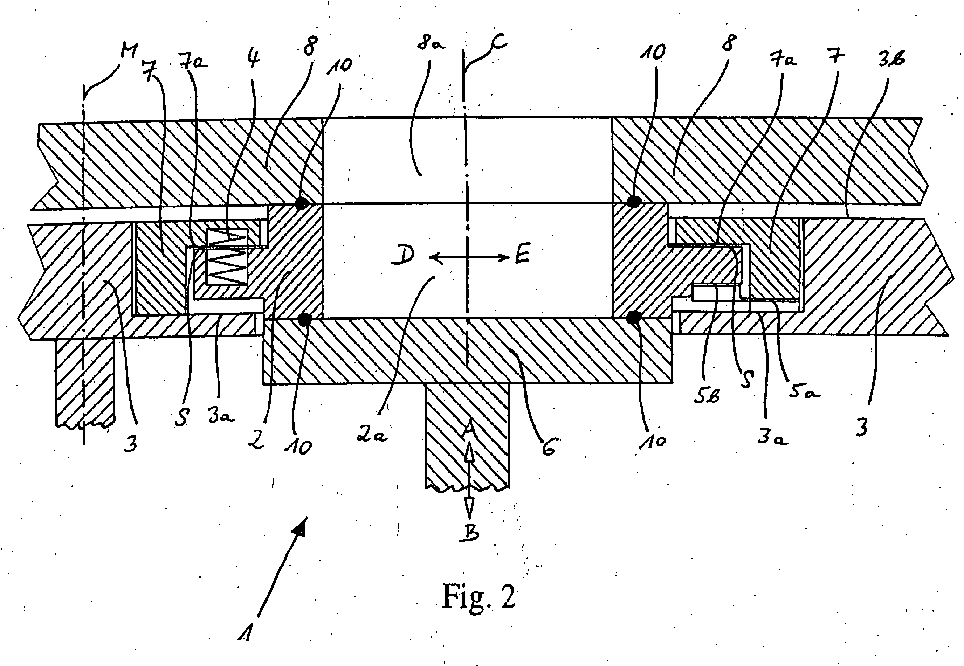

Fig. 1 zeigt eine bevorzugte erfindungsgemäße Ausführung der Trägeranordnung 1, die in einer Vakuumkammer gegenüber einer Öffnung 8a in der Wand 8 der Vakuumkammer angeordnet ist. An die Öffnung 8a kann - in der Zeichnung oberhalb der Wand 8 - eine (nicht dargestellte) Prozeßkammer oder eine Schleuse angeschlossen sein. In einem Träger 3 mit einer Oberfläche 3b, der zum Beispiel ein Drehteller mit einer Drehachse M sein kann, ist ein Trägerelement (Segment) 2 mit einer Öffnung 2a angeordnet, in der ein zu behandelndes Substrat (nicht dargestellt) zum Beispiel für eine CD oder DVD oder eine optische Linse oder ein Brillenglas gehaltert sein kann. Das Trägerelement ist durch mindestens zwei Druckfedern 4 und mindestens zwei Blattfedern 5 verteilt am Umfang (jeweils nur eine davon ist dargestellt) mit einem Überwurfring 7 des Trägers 2 verbunden und in der Zeichnung in vertikaler Richtung längs der Achse C bewegbar. Unterhalb des Trägers 3 und des Trägerelements 2 befindet sich als Hubanordnung ein Hubdeckel 6, der längs der Achse C in Pfeilrichtung A anhebbar oder in Pfeilrichtung B absenkbar ist. In Fig. 1 befindet sich das Trägerelement 2 im Träger 3 in Ruhelage, d.h. das Trägerelement 2 wird durch die Kraft der Druckfedern 4 gegen die Anschlagfläche 3a des Trägers 3 gedrückt, wobei sich der obere Rand des Trägerelements in etwa auf gleichem Niveau mit dem oberen Rand des Trägers 3 und im Abstand zur Unterseite der Kammerwand 8 befindet, so daß sich der Träger 3 in seiner Ebene bewegen, zum Beispiel um die Achse M frei drehen kann. Zwischen dem Überwurfring 7 und dem Trägerelement 2 ist ein ringförmiger Spalt 9 ausgebildet, der eine definierte Breite d aufweist, die zum Beispiel 1-5 mm betragen kann. Der Überwurfring 7 weist eine Anschlagsfläche 7a auf, die die maximale Hubhöhe des Trägerelements 2 begrenzt. In der Vakuumkammerwand 8 und dem Hubdeckel 6 sind weiterhin Vakuumdichtungen 10 vorgesehen, durch die das Trägerelement 2 gegen die Vakuumkammerwand 8 bzw. den Hubdeckel 6 abgedichtet werden kann (vgl. Fig. 2), wenn zum Beispiel die Öffnung 8a Bestandteil einer Schleuse ist.

Fig. 2 zeigt die erfindungsgemäße Ausführungsform gemäß Fig. 1, wobei das Trägerelement 2 an die Vakuumkammerwand 8 im Bereich der Öffnung 8a gedrückt ist, so daß die Öffnung 2a des Trägerelements 2 in direkter Verbindung mit der Öffnung 8a der Kammerwand 8 ist. Dabei besteht vorzugsweise noch ein Spalt S zwischen dem Trägerelement 2 und der Fläche 7a des Überwurfringes 7. In diesem Zustand sind die Druckfedern 4 zusammengedrückt und die Blattfedern 5 sind in Anpreßrichtung A ausgelenkt, so daß das Federteil 5b nach oben gezogen ist. Bezüglich einer seitlichen Bewegung in horizontaler Richtung der Pfeile D oder E sind die Blattfedern starr, so daß in diesen Richtungen eine sehr genaue Positionierung des bewegbaren Teils 2 erfolgt. In der Stellung gemäß Figur 2 kann ein in der Öffnung 2a gehaltertes Substrat (nicht dargestellt) durch die Öffnung 8a beschichtet, z.B. metallisiert werden. Auf die Dichtringe 10 kann in diesem Fall verzichtet werden. Die Öffnungen 2a und 8a können aber auch Bestandteil einer Schleuse für das Substrat sein, das durch die Öffnung 8a entnommen oder eingelegt wird. Die Dichtringe 10 dichten dabei die Schleuse gegen das Hochvakuum der Vakuumkammer ab.

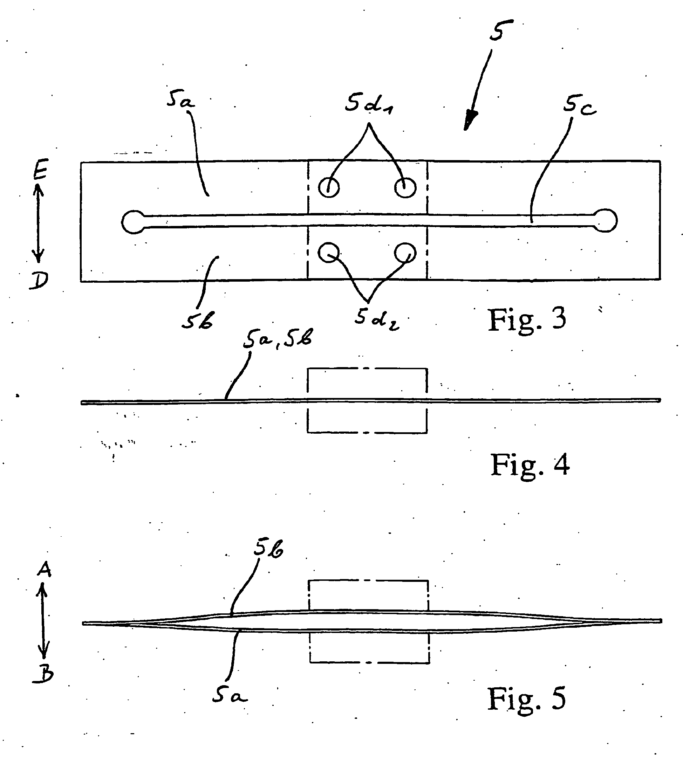

Die Figuren 3 und 4 zeigen eine Blattfeder 5, die in der erfindungsgemäßen Trägeranordnung zum Einsatz kommt. Figur 3 zeigt eine Draufsicht auf die Blattfeder mit den beiden Federteilen 5a und 5b, die durch einen Spalt 5c voneinander getrennt sind und Öffnungen 5d₁ bzw. 5d₂ aufweisen, um die Blattfeder auf der einen Seite mit dem Überwurfring 7 bzw. auf der anderen Seite mit dem bewegbaren Teil 2 zum Beispiel durch Schrauben zu verbinden. Fig. 4 zeigt eine Seitenansicht der Ausführungsform gemäß Fig. 3 im unbelasteten Zustand der Blattfeder 5 (vgl. Fig. 1). Die Blattfedernteile 5a und 5b befinden sich dabei auf gleichem Niveau.

Figur 5 zeigt eine Seitenansicht der Ausführungsform gemäß Figur 4, wobei sich das Blattfedemteil 5b, wie in Figur 2 zu sehen ist, mit dem Trägerelement nach oben bewegt hat und auch die Seitenränder des Federnteils 5a nach oben gebogen sind. Da, wie Figur 3 zeigt, die Blattfeder 5 in den Richtungen E und D nicht elastisch ist, kommt es bei ihrer Auslenkung beim Anheben des Trägerelements auch nicht zu seiner seitlichen Verschiebung, wodurch eine sehr gute Positionierung des Trägerelements erreicht wird.

Im Betrieb wird das Trägerelement 2, das ein Substrathalter sein kann, durch den Träger 3, der ein Drehteller mit der Achse M sein kann, unterhalb der Öffnung 8a der Kammerwand 8, die mit einer Einrichtung zur Behandlung des Substrats oder einer Schleuse verbunden ist, angeordnet. Danach fährt der Hubdeckel 6 in Richtung des Pfeiles A an das bewegbare Teil 2 heran und hebt es aus dem Träger 3 gegen die Kraft der Druckfedern 4 und der Blattfedern 5 heraus und drückt es im Bereich der Öffnung 8a an die Vakuumkammerwand 8 an. Dabei kann die maximale Hubhöhe d, die durch die Breite der Spalte 9 definiert ist, nicht überschritten werden. Die Druckfedern 4 werden zusammengedrückt und die Blattfedern 5 werden in Richtung der Andruckrichtung A ausgelenkt. Bei geschlossener Verbindung der Öffnung 2a und 8a kann das Substrat durch die Öffnung 8a z.B. beschichtet werden oder durch die Öffnung 8a aus- oder eingeschleust werden. Danach wird das Trägerelement 2 von der Vakuumkammerwand 8 durch Zurückfahren des Hubdeckels 6 in Richtung B abgesenkt, bis er auf der Anschlagsfläche 3a des Trägers 3 aufsetzt, wobei bis zum Anschlag durch die Kraft der Druckfeder 4 und der Blattfedern 5 das Trägerelement 2 einen engen Kontakt zum Hubdeckel 6 hat, so daß eine kontinuierliche Bewegung des Trägerelement 2 gewährleistet ist. Danach kann das Substrat in dem Trägerelement 2 mittels z.B. des Drehtellers 3 durch Drehen um die Achse M zu einer anderen nicht dargestellten Position in der Vakuumkammer transportiert werden.

In der dargestellten Ausführungsform ist die Federanordnung in Form von Druckfedern 4 zwischen dem Trägerelement 2 und dem Überwurfring 7 ausgebildet, der nach dem Zusammenbau ortsfest gegenüber dem Träger 3 ist. Alternativ kann diese Federanordnung auch in Form von Zugfedern ausgebildet sein, wobei in diesem Falle die Zugfedern zwischen dem Trägerelement 2 und dem darunterliegenden Anschlag 3a wirksam angeordnet werden, um die in Fig. 1 und 2 dargestellte Ruheposition bzw. Versatzposition des Trägerelements 2 relativ zum Träger 3 zu bewirken.

In der dargestellten Ausführungsform ist der Träger 3 als Drehteller mit der Drehachse M dargestellt, so daß das Trägerelement 2 mit z.B. eingelegtem Substrat in der Trägerebene auf einer Kniebahn transportiert werden kann. Eine andere Bewegung des Trägers 3 in seiner Ebene ist im Rahmen der Erfindung ebenfalls möglich, z.B. eine Linearbewegung oder beliebige Kurvenbewegung in der Trägerebene unter Verwendung einer geeigneten, nicht dargestellten Führungseinrichtung für den Träger 3 anstelle der Drehung um die Achse M.

Im Rahmen der Erfindung ist die Öffnung 2a im Trägerelement 2 nicht notwendig. Zum Beispiel genügt eine Vertiefung an der Oberseite des Trägerelements 2, um dort ein zu transportierendes Substrat einzulegen.

## Patentansprüche

1. Trägeranordnung zum Führen und Positionieren eines Elements an eine Einrichtung (8), mit
(a) einem Träger (3) und einem relativ zum Träger (3) auf einer Hubstrecke (d) zwischen einer Ruheposition (Fig. 1) und einer Versatzposition (Fig. 2) linear bewegbaren Trägerelement (2),
(b) einer Federanordnung (4) zwischen dem Träger (3) und dem Trägerelement (2) zum Vorspannen des Trägerelements (2) in die Ruheposition,
(c) einer Hubanordnung (6) zum Bewegen des Trägerelements (2) aus der Ruheposition in die Versatzposition, und
(d) einer Führungseinrichtung zum Linearführen des Trägerelements (2) in der Hubstrecke zwischen der Ruheposition und der Versatzposition,
**dadurch gekennzeichnet, daß**
(e) die Führungseinrichtung mehrere, vorzugsweise zwei Blattfedern (5) aufweist, die je aus einem Teil (5a) bestehen, das am Träger (3) befestigt ist und aus einem Teil (5b) bestehen, das an dem Trägerelement (2) befestigt ist, und
(f) die Blattfedern (5) das Trägerelement (2) in der Richtung (A) der Hubstrecke fuhren, so daß seine Abweichung längs der Oberfläche (3b) in Richtungen (D oder E) vermieden wird.

2. Trägeranordnung nach Anspruch 1, wobei die Führungseinrichtung Blattfedern (5) aufweist, deren Federenden an dem Träger (3) bzw. am Trägerelement (2) befestigt sind.

3. Trägeranordnung nach Anspruch 1 oder 2, wobei die Einrichtung eine Wand (8) ist.

4. Trägeranordnung nach Anspruch 1, 2 oder 3, wobei die Ruheposition durch einen am Träger befestigten Anschlag (3a) für das Trägerelement (2) und die Versatzposition durch die Einrichtung (8) festgelegt ist.

5. Trägeranordnung nach einem der Ansprüche 1 bis 4, wobei das Trägerelement (2) eine Öffnung (2a) in Richtung der Linearbewegung aufweist.

6. Trägeranordnung nach einem der Ansprüche 1 bis 5, wobei die Federanordnung mindestens zwei, vorzugsweise vier in Azimutrichtung beabstandete Federn (4) aufweist.

7. Trägeranordnung nach einem der Ansprüche 1 bis 6, wobei als Hubanordnung (6) ein Hubdeckel vorgesehen ist, um das Trägerelement (2) gegen die Kraft der Federanordnung (4) und der Blattfedern (5) um eine definierte Spaltbreite (d) längs einer Achse (C) in einer Richtung (A) aus dem Träger (3) herauszuheben.

8. Trägeranordnung nach einem der Ansprüche 1 bis 7 wobei der Träger (3) einen Überwurfring (7) aufweist, der das Trägerelement (2) umgibt, an dem die Federn (4, 5) trägerseitig befestigt sind, der im unbelasteten Zustand der Federn (4, 5) einen Spalt (9) der Breite (d) gegenüber dem Trägerelement (2) ausbildet, wobei das Trägerelement (2) auf einer Anschlagfläche (3a) des Trägers (3) aufsitzt.

9. Trägeranordnung nach einem der Ansprüche 1 bis 8, wobei die Hubstrecke bzw. die Spaltbreite (d) 1 bis 5 mm beträgt.

10. Trägerordnung nach einem der Ansprüche 1 bis 9, wobei der Träger (3) ein Drehteller ist.

11. Trägeranordnung nach einem der Ansprüche 1 bis 10, wobei der Träger (3) ein Substratträger und das Trägerelement (2) ein Substrathalter ist.

12. Trägeranordnung nach einem der Ansprüche 1 bis 11 wobei die Einrichtung (8) eine Öffnung (8a) aufweist und der Abstand zwischen dem Träger (3) mit dem Trägerelement (2) in der Ruhelage und der Einrichtung (8) kleiner als die Spaltbreite (d) ist und das Trägerelement (2) durch die Hubanordnung (6) an die Öffnung (8a) gedrückt wird.

13. Trägeranordnung nach Anspruch 12, wobei die Einrichtung (8) die Wand einer Vakuumkammer ist und die Öffnung (8a) die Öffnung einer Prozeß- oder einer Schleusenkammer ist.

14. Trägeranordnung nach einem der Ansprüche 1 bis 13, wobei die Federanordnung Druckfedern aufweist.

15. Trägeranordnung nach einem der Ansprüche 1 bis 13, wobei die Federanordnung Zugfedern aufweist.

16. Trägeranordnung nach einem der Ansprüche 1 bis 15, wobei die Führungseinrichtung Zugblattfedern aufweist.

17. Trägeranordnung nach einem der Ansprüche 1 bis 15, wobei die Führungseinrichtung Druckblattfedern aufweist.

## Claims

1. A support structure for guiding and positioning an element at an installation (8) comprising:
(a) a support (3) and a support element (2) that is linearly movable with respect to the support (3) on a stroke distance (d) between an idle position (Fig. 1) and a displacement position (Fig. 2);
(b) spring means (4) between the support (3) and the support element (2) for prestressing the support element (2) in the idle position;
(c) lifting means (6) for moving the support element (2) from the idle position into the displacement position; and
(d) guiding means for linearly guiding the support element (2) on the stroke path between the idle position and the displacement position;
**characterised in that**
(e) the guiding means comprises a plurality of springs (5), preferably two leaf springs (5), each consisting of a part (5a) attached to the support (3) and a part (5b) attached to the support element (2); and
(f) the leaf springs (5) guide the support element (2) in the direction (A) of the stroke path so that its deviation along the surface (3b) in the direction (D or E) is avoided.

2. The support structure according to claim 1, wherein the guiding means comprises leaf springs (5) whose spring ends are attached to the support (3) or the support element (2),

3. The support structure according to claim 1 or 2, wherein the installation is a wall (8).

4. The support structure according to claim 1, 2 or 3, wherein the idle position is determined by a stop (3a) for the support element (2), said stop (3a) being attached to the support, whereas the displacement position is determined by the installation (8).

5. The support structure according to claims 1 to 4, wherein the support element (2) comprises an opening (2a) in the direction of the linear movement.

6. The support structure according to any one of claims 1 to 5, wherein the spring means comprises two, preferably four springs (4) spaced apart in the azimuth direction.

7. The support structure according to any one of claims 1 to 6, wherein a lifting cover is provided as the lifting means (6) for lifting the support element (2) against the force of the spring means (4) and the leaf springs (5) from the support (3) by a defined gap width (d) along an axis (C) in the direction (A).

8. The support structure according to any one of claims 1 to 7, wherein the support (3) comprises a coupling ring (7) surrounding the support element (2) to which the springs (4, 5) are attached on the support side and which forms a gap (9) having a width (d) with respect to the support element (2) if the springs (4, 5) are unloaded, wherein the support element (2) rests on the stop surface (3a) of the support (3).

9. The support structure according to any one of claims 1 to 8, wherein the stroke distance or the gap width (d) is 1 to 5 mm.

10. The support structure according to any one of claims 1 to 9, wherein the support (3) is a rotary table.

11. The support structure according to any one of claims 1 to 10, wherein the support (3) is a substrate carrier and the support element (2) is a substrate holder.

12. The support structure according to any one of claims 1 to 11, wherein the installation (8) comprises an opening (8a) and the distance between the support (3) and the support element (2) in the idle position and the installation (8) is smaller than the gap width (d) and the support element (2) is pressed against the opening (8a) by the lifting means (6).

13. The support structure according to claim 12, wherein the installation (8) is the wall of a vacuum chamber and the opening (8a) is the opening of a processing or lock chamber.

14. The support structure according to any one of claims 1 to 13, wherein the spring means comprises pressure springs.

15. The support structure according to any one of claims 1 to 13, wherein the spring means comprises tension springs.

16. The support structure according to any one of claims 1 to 15, wherein the guiding means comprises tension leaf springs.

17. The support structure according to any one of claims 1 to 15, wherein the guiding means comprises pressure leaf springs.

## Revendications

1. Structure de support pour le guidage et le positionnement d'un élément sur une installation (8), comportant
(a) un support (3) et un élément de support (2) déplaçable linéairement par rapport au support (3) sur une course de levage (d) entre une position de repos (Fig. 1) et une position décalée (Fig. 2),
(b) un dispositif à ressort (4) entre le support (3) et l'élément de support (2) pour précontraindre l'élément de support (2) en position de repos,
(c) un dispositif de levage (6) pour déplacer l'élément de support (2) de la position de repos vers la position décalée, et
(d) un mécanisme de guidage pour le guidage linéaire de l'élément de support (2) sur la course de levage entre la position de repos et la position décalée,
**caractérisé en ce que**
(e) le mécanisme de guidage comprend plusieurs, de préférence deux ressorts à lame (5) composés chacun d'une partie (5a) fixée contre le support (3) et d'une partie (5b) fixée contre l'élément de support (2), et
(f) les ressorts à lame (5) guident l'élément de support (2) dans la direction (A) de la course de levage, si bien qu'un écart de celui-ci est évité le long de la surface (3b) dans les directions (D ou E).

2. Structure de support selon la revendication 1, où le mécanisme de guidage comprend des ressorts à lame (5), dont les extrémités de ressorts sont fixées contre le support (3) ou contre l'élément de support (2).

3. Structure de support selon la revendication 1 ou 2, où l'installation est une paroi (8).

4. Structure de support selon la revendication 1, 2 ou 3, où la position de repos est définie par une butée (3a) pour l'élément de support (2) fixée contre le support, et la position décalée par l'installation (8).

5. Structure de support selon l'une des revendications 1 à 4, où l'élément de support (2) présente une ouverture (2a) dans la direction du déplacement linéaire.

6. Structure de support selon l'une des revendications 1 à 5, où le dispositif à ressort comprend au moins deux, de préférence quatre ressorts (4) espacés en direction azimutale.

7. Structure de support selon l'une des revendications 1 à 6, où un couvercle de levage est prévu comme dispositif de levage (6), pour soulever l'élément de support (2) du support (3) d'une largeur de fente (d) définie le long d'un axe (C) dans une direction (A), contre la force du dispositif à ressort (4) et des ressorts à lame (5).

8. Structure de support selon l'une des revendication 1 à 7, où le support (3) comprend une bague d'accouplement (7) qui entoure l'élément de support (2), contre laquelle les ressorts (4, 5) sont fixés côté support, et qui en état non contraint des ressorts (4, 5) forme une fente (9) de largeur (d) par rapport à l'élément de support (2), l'élément de support (2) reposant sur une surface de butée (3a) du support (3).

9. Structure de support selon l'une des revendications 1 à 8, où la course de levage ou la largeur de fente (d) sont comprises entre 1 et 5 mm.

10. Structure de support selon l'une des revendications 1 à 9, où le support (3) est un plateau rotatif.

11. Structure de support selon l'une des revendications 1 à 10, où le support (3) est un support de substrat et l'élément de support (2) un maintien de substrat.

12. Structure de support selon l'une des revendications 1 à 11, où l'installation (8) présente une ouverture (8a), où l'espacement entre le support (3) avec l'élément de support (2) en position de repos et l'installation (8) est inférieur à la largeur de fente (d), et où l'élément de support (2) est serré contre l'ouverture (8a) par le dispositif de levage (6).

13. Structure de support selon la revendication 12, où la paroi (8) est l'installation d'une chambre à vide et où l'ouverture (8a) est l'ouverture d'une chambre de processus ou d'un sas. '

14. Structure de support selon l'une des revendications 1 à 13, où le dispositif à ressort comprend des ressorts de pression.

15. Structure de support selon l'une des revendications 1 à 13, où le dispositif à ressort comprend des ressorts de traction.

16. Structure de support selon l'une des revendications 1 à 15, où le mécanisme de guidage comprend des ressorts de traction à lame.

17. Structure de support selon l'une des revendications 1 à 15, où le mécanisme de guidage comprend des ressorts de pression à lame.
